# FASCICULE DE BREVET EUROPEEN

(11) **EP 0 414 594 B1**
(45) Date de publication et mention de la délivrance du brevet: **05.04.1995**
(21) Numéro de dépôt: 90402303.3
(22) Date de dépôt: 16.08.1990
(51) Int. Cl.: H01L 21/768, H01L 23/538

(54) **Procédé de réparation d'un dispositif à substrat porteur de circuits intégrés**
Reparaturverfahren für eine Vorrichtung mit integrierten Schaltkreisen auf einem Trägersubstrat
Method of repairing a device comprising integrated circuits on a carrier substrate

(30) Priorité: 18.08.1989 FR 8911013
(43) Date de publication de la demande: 27.02.1991
(73) Titulaire: COMMISSARIAT A L'ENERGIE ATOMIQUE, 75015 Paris Cédex 15 (FR)
(72) Inventeur: Marion, François, F-38120 Saint Egreve (FR); Ravetto, Michel, F-38170 Seyssinet-Pariset (FR)
(74) Mandataire: Dubois-Chabert, Guy

(56) Documents cités:
- EP-A- 0 078 165
- DE-A- 3 638 799
- US-A- 3 528 048
- US-A- 3 766 308
- US-A- 3 766 308
- US-A- 4 814 283
- PATENT ABSTRACTS OF JAPAN, vol. 8, no. 176 (E-260)[1613], 14 août 1984;& JP-A-59 69 961
- Patent Abstracts of Japan, vol. 9, no. 47 (E-299); & JP-A-59 188 155

## Description

L'invention se rapporte à un procédé de réparation d'un dispositif à substrat porteur de circuits intégrés à relier entre eux à la connexion des circuits au reste du dispositif.

On s'intéresse ici à la connexion électrique irréversible entre deux pistes conductrices établies sur un support de circuit intégré. La technique la plus communément employée jusqu'à présent consiste à déposer localement du matériau conducteur en utilisant un masque (anti-flash).

L'invention comprend l'utilisation d'un mode de connexion électrique avec une mise en oeuvre fort simple. Les propriétés de tension superficielle à l'état liquide de certains matériaux tels que l'indium, couramment utilisés pour établir les connexions, sont utilisées, comme dans le brevet US-A-3 528 048 qui mentionne également comment établir des déconnexions électriques en exploitant un phénomène analogue.

Un élément de connexion comprend sur chacune des pistes une surface mouillable par un matériau conducteur électrique porté à l'état liquide ainsi qu'une galette faite du matériau conducteur, les galettes comprenant chacune une zone extrême sur une des surfaces mouillables et s'étendant, à partir de cette zone extrême, en direction opposée à l'autre surface mouillable.

L'invention concerne un procédé de réparation d'un dispositif porteur de circuits intégrés dont certains sont défectueux à l'aide de circuits de rechange conformément à la revendication 1.

On va maintenant décrire l'invention plus en détail à l'aide des figures suivantes annexées à titre illustratif et non limitatif :
- les figures 1 et 2 représentent deux vues de côté et de dessus d'un élément de connexion ;
- la figure 3 représente le même élément après connexion ;
- la figure 4 représente un dispositif de grande taille ; et
- les figures 5 et 6 représentent deux étapes d'un procédé de réparation sur le dispositif de la figure 4.

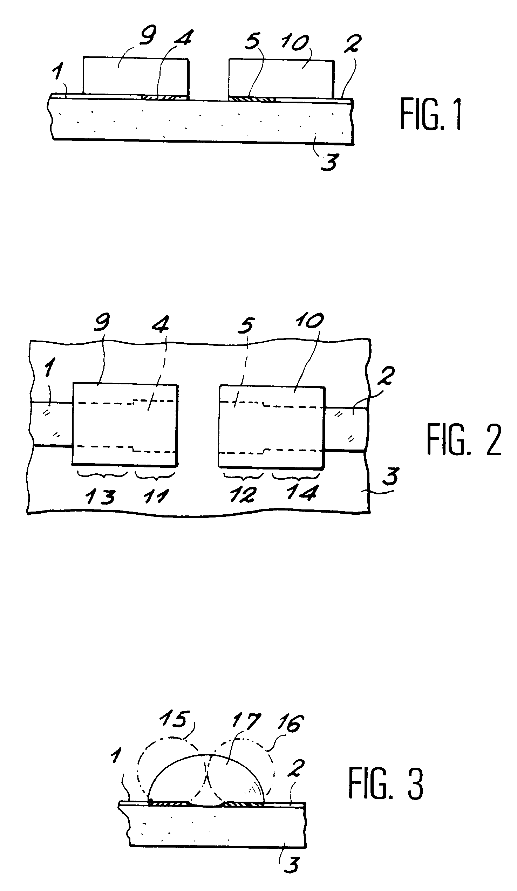

Sur les figures 1 et 2, on note deux pistes conductrices électriques 1 et 2 sur un support 3 qui peut porter un ou plusieurs circuits intégrés. Les pistes 1 et 2 se terminent face à face et sont munies à leur extrémité d'une pellicule d'or 4 et 5.

L'élément de connexion se compose de deux galettes d'indium 9 et 10 planes, séparées et présentant chacune une partie d'extrémité, respectivement 11 et 12, disposée sur la pellicule 4 ou 5 associée et une partie complémentaire, respectivement 13 et 14, contiguë à la partie d'extrémité 11 ou 12 et s'étendant à partir de celle-ci, en direction opposée à l'autre pellicule, respectivement 5 et 4.

Pour établir la connexion électrique entre les pistes 1 et 2, on chauffe les galettes 9 et 10 pour les fondre. Les forces de tension superficielle libérées réarrangent la matière des galettes 9 et 10 en deux billes tronquées 15 et 16 (figure 3) dont les volumes sont suffisamment importants pour qu'elles se joignent. La modification des forces de tension superficielle qui résulte de cette jonction conduit à la coalescence des deux billes 15 et 16 en une gouttelette unique 18 qui unit donc désormais les pistes 1 et 2 et fournit une connexion électrique. On laisse ensuite la gouttelette 17 refroidir pour se solidifier.

L'utilisation de tels éléments de connexion peut prendre place sur un dispositif de grande taille supportant des circuits intégrés élémentaires à interconnecter tels que des mémoires alignées et où l'on éprouve le besoin de vérifier les circuits intégrés l'un après l'autre pour les remplacer quand ils sont défectueux.

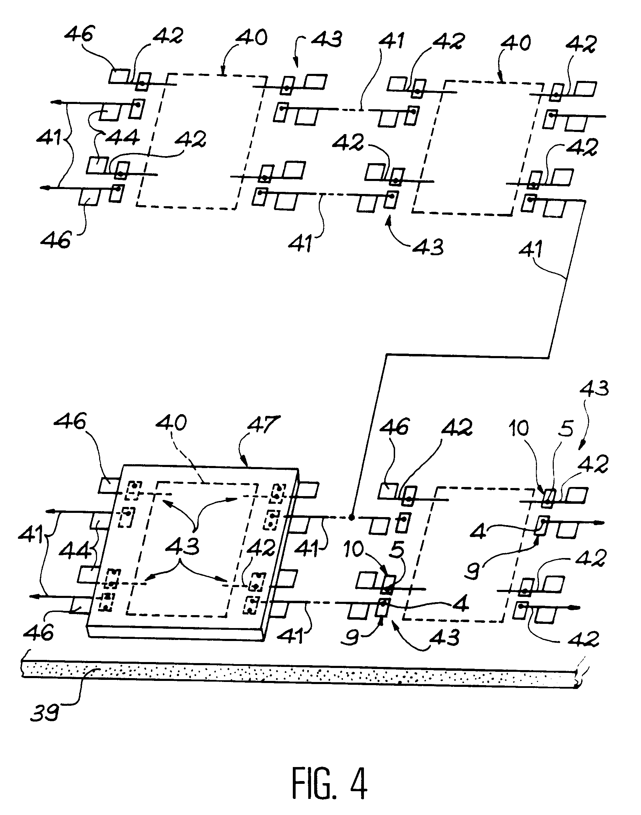

Un dispositif porteur de circuits intégrés est représenté à la figure 4 et a été conçu pour permettre des opérations de réparation et de mise en service très faciles. Un support est référencé par 39, des circuits intégrés par 40, des lignes d'interconnexion par 41 et des lignes de raccordement par 42 ; les lignes d'interconnexion 41 s'étendent chacune entre deux circuits intégrés 40 sans toutefois les atteindre, mais les lignes de raccordement 42 s'étendent chacune, à partir d'un circuit intégré 40, parallèlement à une ligne d'interconnexion 41 associée et près de cette ligne 41. Les éléments de connexion, reférencés ici par 43, établis à la fois sur une ligne d'interconnexion 41 et une ligne de raccordement 42 ont donc des galettes 9 et 10 qui s'étendent à partir des pellicules 4 et 5 perpendiculairement auxdites lignes 41 et 42. Les lignes d'interconnexion 41 sont en outre pourvues de plots de vérification 44 à chacune de leurs extrémités, et de même chaque ligne de raccordement 42 est terminée par un plot de vérification 46.

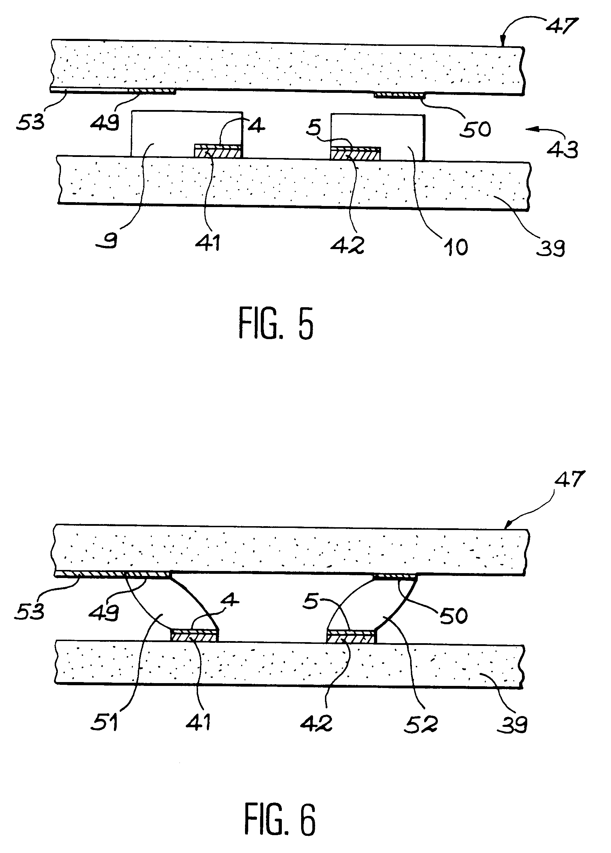

Les plots de vérification 44 et 46 permettent de contrôler respectivement, au cours d'une étape préliminaire à la mise en service du dispositif, la continuité des lignes d'interconnexion 41 et le bon état des circuits intégrés 40. Les circuits intégrés 40 incorrects sont remplacés par des circuits de réparation 47 placés au-dessus d'eux. Comme on le voit sur la figure 5, la face de dessous des circuits de réparation 47 est pourvue de paires de surfaces mouillables 49 et 50 qui viennent au-dessus des éléments de connexion 43, mais les surfaces mouillables 49 et 50 du circuit de réparation 47 sont plus écartées que celles 4 et 5 sur la ligne d'interconnexion 41 et la ligne de raccordement 42 et s'étendent au-dessus des parties des galettes 9 et 10 qui sont établies à côté des lignes 41 et 42.

Les connexions nécessaires à la mise en service du dispositif sont obtenues par une étape unique de chauffage d'ensemble du dispositif, ce qui fait fondre les galettes des éléments de connexion 43. Les gouttelettes ainsi produites se redressent librement et subissent une coalescence lorsqu'elles ne sont pas surplombées par un circuit de réparation 47 : on retrouve le phénomène décrit à l'aide de la figure 3, qui aboutit donc à connecter les circuits intégrés 40 en bon état aux lignes d'interconnexion 41. Mais les choses se présentent différemment pour les éléments de connexion 43 au-dessous de circuits de réparation 47 : les gouttelettes sont interceptées par les surfaces mouillables 49 et 50 du circuit de réparation 47 dès qu'elles se redressent, et s'étalent sur elles. Quand la solidification intervient, on obtient (figure 6) deux billes 51 et 52 inclinées chacune à l'opposé de l'autre, et donc la première 51 relie une ligne d'interconnexion 41 à une ligne de raccordement 53 établie en dessous du circuit de réparation 47 et en contact avec la surface mouillable 49, tandis que la seconde bille 52 relie la ligne de raccordement 42 établie sur le dispositif de support 39 à la surface mouillable 50, qui est isolée électriquement du reste du circuit de réparation 47.

On constate que les éléments de connexion 43 servent également d'éléments de soudure dans cette réalisation ; les billes 52 sans rôle de connexion électrique sont cependant utiles pour raffermir la liaison mécaniques des circuits de réparation 47 sur le support 39.

L'invention s'étend évidemment à tous les matériaux déjà utilisés dans cette technique et qui présentent des propriétés analogues.

## Revendications

1. Procédé de réparation d'un dispositif comprenant : un substrat (39) ; des circuits intégrés (40) sur le substrat ; des lignes électriques de connexion (41, 42) reliant les circuits intégrés (40) et sur le substrat ; des premières surfaces mouillables (4, 5) par un matériau de soudure conducteur électrique, les surfaces étant associées par paires, les surfaces de chaque paire étant situées sur des portions adjacentes de deux, différentes, des lignes électriques ; des galettes plates (9, 10) du matériau de soudure s'étendant chacune sur une des surfaces et au-delà de ladite surface, en direction opposée à l'autre des surfaces de la même paire ; ledit procédé comprenant les étapes suivantes : vérifier les circuits intégrés pour chercher parmi eux des circuits défectueux ; placer des circuits de réparation (47) au-dessus des circuits défectueux, les circuits de réparation comprenant des lignes de connexion électrique (53) et des secondes surfaces mouillables (49, 50) par le matériau de soudure, chaque seconde surface mouillable s'étendant au-dessus d'une des premières surfaces mouillables ; chauffer le substrat pour que les galettes (9, 10) sur chaque première surface fondent et se transforment en gouttelettes qui soit s'étalent sur l'une des secondes surfaces mouillables, soit fusionnent avec la gouttelette de la galette fondue de l'autre première surface mouillable de la même paire s'il n'est pas de seconde surface mouillable au-dessus d'elles ; et laisser le substrat refroidir et les gouttelettes se solidifier.

2. Procédé suivant la revendication 1, caractérisé en ce que les secondes surfaces mouillables (49, 50) sont associées par secondes paires, les surfaces mouillables de chacune des secondes paires étant séparées de plus grands intervalles que les surfaces mouillables (4, 5) de la première paire respective au-dessus desquelles elles s'étendent.

## Patentansprüche

1. Reparaturverfahren für eine Vorrichtung, umfassend: ein Substrat (39); integrierte Schaltungen (40) auf dem Substrat; elektrischen Verbindungsleitungen (41, 42), die integrierten Schaltungen (40) verbindend und auf dem Substrat; erste durch ein elektrisch leitendes Lötmaterial benetzbare Flächen (4, 5), wobei die Flächen paarweise verbunden sind und die Flächen jedes Paares sich auf benachbarten Teilstücken von zwei, verschiedenen, der elektrischen Leitungen befinden; flache Lötmaterialbatzen (9, 10), von denen jeder sich auf einer der Fläche und über die besagte Fläche hinaus erstreckt, in entgegengesetzter Richtung bezüglich der anderen der Flächen desselben Paares;
dabei umfaßt das genannte Verfahren die folgenden Schritte: Überprüfen der integrierten Schaltungen, um unter ihnen nach defekten Schaltungen zu suchen; Anbringen von Reparaturschaltungen (47) über den defekten Schaltungen, wobei die Reparaturschaltungen elektrische Verbindungsleitungen (53) umfassen und zweite, durch das Lötmaterial benetzbare Flächen (49, 50), wobei jede benetzbare zweite Fläche sich über einer der benetzbaren ersten Flächen erstreckt; Erwärmen des Substrats, damit die Batzen (9, 10) auf jeder ersten Fläche schmelzen und sich zu Tröpfen umformen, die sich entweder ausbreiten auf einer der benetzbaren zweiten Flächen, oder sich vereinigen mit dem Tröpfchen des geschmolzenen Batzens der anderen, ersten benetzbaren Fläche desselben Paares, wenn keine benetzbare zweite Fläche über ihnen vorhanden ist; und das Substrat abkühlen und die Tröpfchen erstarren lassen.

2. Verfahren nach Anspruch 1, dadurch gekennzeichnet, daß die benetzbaren zweiten Flächen (49, 50) verbunden sind durch zweite Paare, wobei die benetzbaren Flächen von jedem der zweiten Paare durch größere Abstände getrennt sind als die benetzbaren Flächen (4, 5) des jeweiligen ersten Paares, über denen sie sich erstrecken.

## Claims

1. Process for the repair of a device comprising a substrate (39), integrated circuits (40) on the substrate, electrical connection lines (41, 42) connecting the integrated circuits (40) and on the substrate, first surfaces (4, 5) wettable by an electrically conductive welding material, the surfaces being combined in pairs, the surfaces of each pair being located on adjacent portions of two different electric lines, planar wafers (9, 10) of the welding material extending in each case on one of the surfaces and beyond said surface, in the opposite direction to the other of the surfaces of the same pair, said process comprising the following stages;
checking the integrated circuits in order to seek defective circuits among them, placing replacement circuits (47) above the defective circuits, the replacement circuits having electrical connection lines (53) and second surfaces (49, 50) wettable by the welding material, each second, wettable surface extending above one of the first wettable surfaces, heating the substrate so that the wafers (9, 10) on each first surface melt and are transformed into droplets which either spread over one of the second wettable surfaces, or merge with the droplet of the melted wafer of the other first wettable surface of the same pair if there is no second wettable surface above them and allowing the substrate to cool and the droplets to solidify.

2. Process according to claim 1, characterized in that the second wettable surfaces (49, 50) are combined by second pairs, the wettable surfaces of each of the second pairs being separated by larger gaps than the wettable surfaces (4, 5) of the first respective pair above which they extend.
